# EUROPÄISCHE PATENTSCHRIFT

(11) **EP 1 078 453 B1**
(45) Veröffentlichungstag und Bekanntmachung des Hinweises auf die Patenterteilung: **16.04.2003**
(21) Anmeldenummer: 99932664.8
(22) Anmeldetag: 07.05.1999
(51) Int. Cl.: H03H 9/00

(54) **DÜNNFILM-PIEZORESONATOR**
THIN-LAYERED PIEZO-RESONATOR
RESONATEUR PIEZO A COUCHES MINCES

(30) Priorität: 08.05.1998 DE 19820755
(43) Veröffentlichungstag der Anmeldung: 28.02.2001
(73) Patentinhaber: Infineon Technologies AG, 81669 München (DE)
(72) Erfinder: AIGNER, Robert, D-81675 München (DE)
(74) Vertreter: Ginzel, Christian
(86) Internationale Anmeldenummer: DE9901393
(87) Internationale Veröffentlichungsnummer: WO99059244

(56) Entgegenhaltungen:
- WO-A-96/10270
- LAU W W ET AL: "LATERAL-FIELD-EXCITATION ACOUSTIC RESONATORS FOR MONOLITHIC OSCILLATORS AND FILTERS" PROCEEDINGS OF THE 1996 IEEE INTERNATIONAL FREQUENCY CONTROL SYMPOSIUM. (50TH ANNIVERSARY), HONOLULU, HAWAII, JUNE 5 - 7, 1996,5. Juni 1996 (1996-06-05), Seiten 558-562, XP000699002 INSTITUTE OF ELECTRICAL AND ELECTRONICS ENGINEERS ISBN: 0-7803-3310-1
- J.L.HOKANSON: "Laser-Machining Thin-Film Electrode Arrays on Quartz Crystal Substartes" JOURNAL OF APPLIED PHYSICS., Bd. 40, Nr. 8, Juli 1969 (1969-07), Seiten 3157-3160, XP002120509 AMERICAN INSTITUTE OF PHYSICS. NEW YORK., US ISSN: 0021-8979

## Beschreibung

Die vorliegende Erfindung betrifft einen Dünnfilm-Piezoresonator, der mit den Methoden der Mikromechanik herstellbar ist.

Die Resonanzfrequenz von Dünnfilm-Piezoresonatoren im Frequenzbereich über 500 MHz ist indirekt proportional zur Schichtdicke der Piezoschicht. Die Trägermembran sowie die Boden- und Deckelelektroden stellen eine zusätzliche Massenbelastung für den Resonator dar, die eine Reduzierung der Resonanzfrequenz bewirkt. Die Dickenschwankungen in allen diesen Schichten bestimmen den Bereich der Fertigungstoleranzen, in dem die Resonanzfrequenz eines Exemplars des Resonators liegt. Für Sputterprozesse in der Mikroelektronik sind Schichtdickenschwankungen von 5 % typisch, mit erheblichem Aufwand können 1 % erreicht werden. Schwankungen treten sowohl statistisch von Scheibe zu Scheibe als auch systematisch zwischen Scheibenmitte und Rand auf. Für Filter im GHz-Bereich müssen die Resonanzfrequenzen einzelner Resonatoren zumindest eine absolute Genauigkeit von 0,5 % aufweisen.

Für hochselektive Filter müssen mehrere Resonatoren in Leiter-, Gitter- oder Parallelkonfiguration verschaltet werden. Die individuellen Resonatoren müssen gezielt zueinander verstimmt werden, um die gewünschte Filtercharakteristik zu erreichen. Vorzugsweise werden aus Kostengründen alle Resonatoren eines Filters aus einer Piezoschicht konstanter Dicke hergestellt; die Frequenzabstimmung erfolgt durch additive Schichten auf den Deckelelektroden. Für jede vorkommende Resonanzfrequenz muß eine Zusatzschicht unterschiedlicher Dicke hergestellt werden. Das erfordert jeweils einen Abscheideoder Ätzschritt, verbunden mit einem Lithografieschritt. Um diesen Aufwand zu begrenzen, werden üblicherweise nur Filtertopologien hergestellt, mit denen nur zwei Resonanzfrequenzen eingestellt werden.

Aus "J. L. Hokanson: *Laser-Machining Thin-Film Electro*de *Arrays on Quarz Crystal Substrates,* Journal of Applied Physics., Bd. 40, Nr. 8, Juli 1969 (1969-07), Seiten 3157-3160, ist bekannt, die Resonatorfrequenz eines 5 MHz Quarzresonators dadurch zu verändern, dass in einer oberen Goldelektrode, die auf dem Quarzkristall angebracht ist, Löcher erzeugt werden.

Aus "Lau W. et al: Lateral-Field_Exication Accoustic Resonators for monolithic Oscillators and Filters, Proceedings of the 1996 IEEE International Frequency Control Symposium, Honolulu, Hawaii, 5. Juni 1996, Seiten 558 - 562, sind LFE- PBARs bekannt, in denen auf einer piezoelektrischen Zno-Schicht zwei Al-Elektroden nebeneinander angeordnet sind.

Die Resonanzfrequenz von Dünnfilm-Piezoresonatoren kann grundsätzlich dadurch getrimmt werden, daß Zusatzschichten wie oben beschrieben aufgebracht werden, was aber eine aufwendige Lithografie erforderlich macht. Mit Laser-Trimmen oder Ionenstrahltrimmen läßt sich ganzflächig Material abtragen, was die Masse der Deckelschicht verringert, aber einen teuren Fertigungsschritt am Ende des Fertigungsprozesses erforderlich macht. Mit angeschlossenen Kapazitäten oder einer angelegten Gleichspannung kann die Resonanzfrequenz zwar verschoben werden; der Trimmbereich ist aber vergleichsweise eng. Das gleiche gilt für thermisches Trimmen durch Aufheizen des Resonators.

Aufgabe der vorliegenden Erfindung ist es, einen Dünnfilm-Piezoresonator anzugeben, der mit einfachen Mitteln und hoher Genauigkeit auf eine vorgegebene Resonanzfrequenz eingestellt werden kann. Außerdem soll angegeben werden, wie sich auf einfache Weise mehrere Resonanzfrequenzen einstellen lassen.

Diese Aufgabe wird mit dem Dünnfilm-Piezoresonator mit den Merkmalen des Anspruches 1 bzw. mit der Anordnung mit den Merkmalen des Anspruches 6 gelöst. Ausgestaltungen ergeben sich aus den abhängigen Ansprüchen.

Der erfindungsgemäße Dünnfilm-Piezoresonator ist in in einer eigens dafür aufgebrachten Zusatzschicht mit vorzugsweise lithografisch hergestellten Löchern oder ähnlichen Strukturierungen versehen, die einen mittleren Abstand voneinander haben, der geringer ist als die vorgesehene akustische Wellenlänge im Betrieb des Bauelementes. Diese Strukturierungen sind vorzugsweise so ausreichend gleichmäßig verteilt, daß eine gleichmäßige Änderung der Masse der Schicht pro Fläche (Flächendichte) bewirkt ist und damit eine gezielte Einstellung der Resonanzfrequenz(en) erfolgt, und anderseits so unregelmäßig verteilt, daß Beugungseffekte vermieden werden.

Es folgt eine genauere Beschreibung des erfindungsgemäßen Dünnfilm-Piezoresonators anhand der Figuren 1 bis 3.
Figur 1 zeigt ein Ausführungsbeispiel eines erfindungsgemäßen Resonators im Querschnitt.
Figur 2 zeigt den in Figur 1 gekennzeichneten Ausschnitt in einer Vergrößerung.
Figur 3 zeigt die Strukturierung der oberen Schicht in Aufsicht.

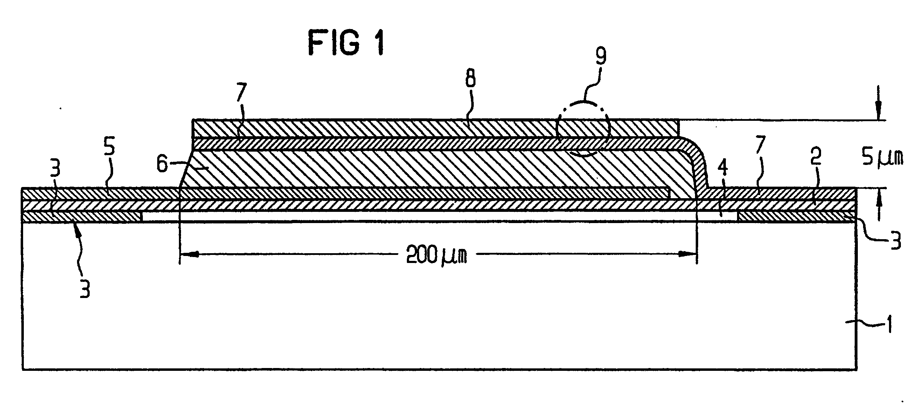

Figur 1 zeigt ein Beispiel eines erfindungsgemäßen Resonators im Querschnitt. Auf einem Substrat 1 befindet sich eine Trägerschicht 2, die vorzugsweise Polysilizium ist und unter der sich im Bereich einer als Resonator vorgesehenen Schichtstruktur ein Hohlraum 4 in einer Hilfsschicht 3 z. B. aus Oxid befindet. Der Hohlraum besitzt typisch die eingezeichnete Abmessung von etwa 200 µm. Auf der Trägerschicht 2 befindet sich die Schichtstruktur des Resonators aus einer für die Bodenelektrode vorgesehenen unteren Elektrodenschicht 5, einer Piezoschicht 6 und einer für die Deckelelektrode vorgesehenen oberen Elektrodenschicht 7. Die Elektrodenschichten 5, 7 sind vorzugsweise Metall, und die Piezoschicht 6 ist z. B. AlN, ZnO oder PZT-Keramik (PbZrTi). Diese Schichtstruktur besitzt insgesamt typisch die eingezeichnete Dicke von etwa 5 µm.

Erfindungsgemäß sind in der auf der oberen Elektrodenschicht 7 aufgebrachten weiteren und im folgenden als Zusatzschicht 8 bezeichneten Schicht vorzugsweise fotolithografisch hergestellte Atzstrukturen vorhanden, die die Resonanzfrequenz oder mehrere unterschiedliche Resonanzfrequenzen in der vorgesehenen Weise festlegen. In dem in der Figur 1 dargestellten Beispiel befinden sich diese Ätzstrukturen in der Zusatzschicht 8.

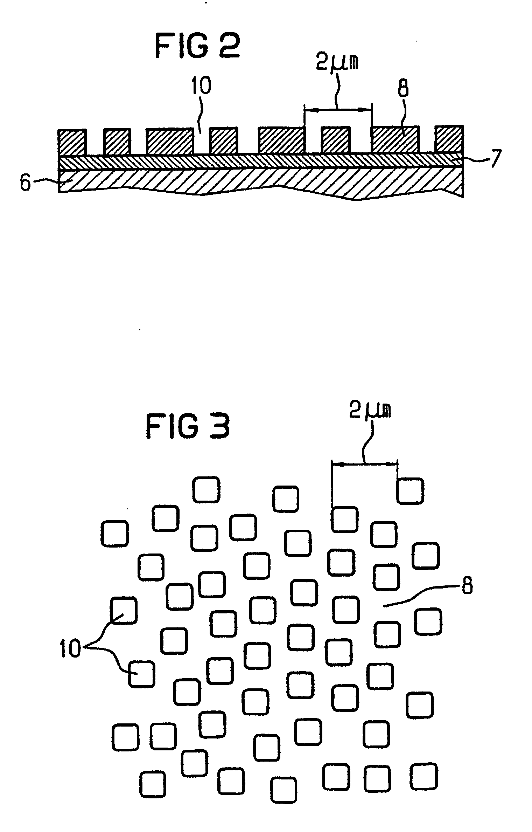

Figur 2 zeigt den in Figur 1 mit einem Kreis 9 bezeichneten Ausschnitt in einer Vergrößerung, in der die Struktur der Zusatzschicht 8 auf der oberen Elektrodenschicht 7 und der Piezoschicht 6 erkennbar ist. Die Zusatzschicht 8 ist in diesem Beispiel durch eine Vielzahl von Löchern 10 perforiert. Über die Dichte der Verteilung dieser Löcher 10 ist die effektive Massenbelastung des Resonators und damit die Resonanzfrequenz gezielt eingestellt. Bei einer Frequenz von 1 GHz liegt die akustische Wellenlänge gängiger Dünnfilm-Piezomaterialien im Bereich von 5 µm bis 10 µm. Sind die Löcher der Perforation und deren Abstand deutlich kleiner als die akustische Wellenlänge, so ist die Perforation für die akustische Welle unscharf und bewirkt keine Streuung der Welle; die Perforation wirkt auf die Welle als Änderung der mittleren Dichte des Materials. Ein weiterer Vorteil, der erzielt wird, ist die Streuung höherer Moden des Resonators an den Löchern, so daß der unerwünschte Einfluß dieser Moden auf die Filtercharakteristik abnimmt.

Figur 3 zeigt die Zusatzschicht 8 in Aufsicht, so daß die Lage der Löcher 10 (hier näherungsweise quadratisch) erkennbar ist. Statt einzelner Löcher in der Zusatzschicht 8 können zusammenhängende Zwischenräume vorhanden sein, die z. B. den gesamten Bereich zwischen den in Figur 3 dargestellten quadratischen Bereichen 10 einnehmen. Diese Bereiche bilden dann Inseln 10 aus dem Material der Zusatzschicht 8. Wesentlich ist an der vorhandenen Strukturierung, daß die ausgesparten Bereiche der strukturierten Schicht bzw. die verbliebenen Inseln so angeordnet sind, daß die gewünschte Einstellung der Resonanzfrequenz erreicht wird.

Durch gezielte und ggf. (z. B. unter Verwendung von Steppern) örtlich variierende Über- oder Unterbelichtung bei der Lithografie können bei der Herstellung des Resonators Schwankungen der Schichtdicke ausgeglichen werden. Beliebig viele Resonanzfrequenzen können ohne Zusatzaufwand mit mehreren entsprechend ausgeführten Resonatoren auf demselben Chip realisiert werden. Bei der Herstellung brauchen dafür nur der Abstand und die Größe der Löcher in der für die Lithografie verwendeten Maske verändert zu werden. Insbesondere Filter mit parallelen Resonatoren und Filterbänke zur Auftrennung von Frequenzbändern lassen sich so einfach realisieren.

## Patentansprüche

1. Dünnfilm-Piezoresonator mit einer Piezoschicht (6) zwischen einer unteren Elektrodenschicht (5) und einer oberen Elektrodenschicht (7),
**dadurch gekennzeichnet,**
**dass**
auf der oberen Elektrodenschicht (7) eine Zusatzschicht (8) aufgebracht ist und in der Zusatzschicht (1) eine die mittlere Dichte der Zusatzschicht bestimmende Struktur vorhanden ist, mit der eine vorgesehene Resonanzfrequenz eingestellt ist.

2. Dünnfilm-Piezoresonator nach Anspruch 1,
bei dem die Struktur Löcher (10) umfasst und
bei dem der Abstand zwischen je einem dieser Löcher und dem dazu nächstgelegenen Loch geringer ist als eine für den Betrieb des Resonators vorgesehene Wellenlänge.

3. Dünnfilm-Piezoresonator nach Anspruch 1,
bei dem die Struktur Inseln (10) umfasst und
bei dem der Abstand zwischen je einer dieser Inseln und der dazu nächstgelegenen Insel geringer ist als eine für den Betrieb des Resonators vorgesehene Wellenlänge.

4. Dünnfilm-Piezoresonator nach einem der Ansprüche 1 bis 3, bei dem die Struktur so unregelmäßig ist, dass Beugungserscheinungen vermieden sind.

5. Dünnfilm-Piezoresonator nach einem der Ansprüche 1 bis 4, bei dem die Piezoschicht (6) ein Material aus der Gruppe von AlN, ZnO und PZT-Keramik ist,
bei dem die Piezoschicht (6) und die Elektrodenschichten (5, 7) auf einer Trägerschicht (2) aus Polysilizium angeordnet sind und
bei dem auf der von der unteren Elektrodenschicht (5) abgewandten Seite dieser Trägerschicht ein Hohlraum (4) vorhanden ist.

6. Anordnung aus mehreren Dünnfilm-Piezoresonatoren nach je einem der Ansprüche 1 bis 5,
bei der die Resonatoren auf demselben Chip angeordnet sind und
bei der die Resonatoren auf mindestens drei verschiedene Resonanzfrequenzen eingestellt sind.

## Claims

1. Thin film piezoelectric resonator having a piezoelectric layer (6) between a lower electrode layer (5) and an upper electrode layer (7), **characterized in that** an additional layer (8) is applied to the upper electrode layer (7), and a structure which determines the average density of the additional layer and with the aid of which a prescribed resonant frequency is set is present in the additional layer (1).

2. Thin film piezoelectric resonator according to Claim 1, in which the structure comprises holes (10), and in which the spacing between each one of these holes and the hole closest thereto is smaller than a wavelength provided for operating the resonator.

3. Thin film piezoelectric resonator according to Claim 1, in which the structure comprises islands (10) and in which the spacing between each one of these islands and the island closest thereto is smaller than a wavelength provided for operating the resonator.

4. Thin film piezoelectric resonator according to one of Claims 1 to 3, in which the structure is so irregular that defraction phenomena are avoided.

5. Thin film piezoelectric resonator according to one of Claims 1 to 4, in which the piezoelectric layer (6) is a material from the group of AlN, ZnO and PZT ceramic in which the piezoelectric layer (6) and the electrode layers (5, 7) are arranged on a carrier film (2) made from polysilicon, and in which a cavity (4) is present on the side of this carrier film averted from the lower electrode layer (5).

6. Arrangement of a plurality of thin film piezoelectric resonators according to each one of Claims 1 to 5, in which the resonators are arranged on the same chip, and in which the resonators are set to at least three different resonant frequencies.

## Revendications

1. Résonateur piézo-électrique à couches minces, comprenant une couche (6) piézo-électrique, entre une couche (5) inférieure formant électrode et une couche (7) supérieure formant électrode, **caractérisé en ce que**
il est déposé une couche (8) supplémentaire sur la couche (7) supérieure formant électrode, et il est prévu dans la couche (8) supplémentaire une structure qui détermine la masse volumique moyenne de la couche supplémentaire, et par laquelle est réglée une fréquence de résonance prévue.

2. Résonateur piézo-électrique à couches minces suivant la revendication 1, dans lequel la structure comprend des trous (10) et dans lequel la distance, entre respectivement l'un de ces trous et le trou le plus voisin, est inférieure à une longueur d'onde prévue pour le fonctionnement du résonateur.

3. Résonateur piézo-électrique suivant la revendication 1, dans lequel la structure comprend des îlots (10) et dans lequel la distance, entre respectivement l'un de ces îlots et l'îlot le plus voisin, est plus petite qu'une longueur d'onde prévue pour le fonctionnement du résonateur.

4. Résonateur piézo-électrique suivant l'une des revendications 1 à 3, dans lequel la structure est si irrégulière que des phénomènes de diffraction sont évités.

5. Résonateur piézo-électrique suivant l'une des revendications 1 à 4, dans lequel la couche (6) piézo-électrique est un matériau choisi dans le groupe constitué d'AIN, de ZnO et de céramique PZT, dans lequel la couche (6) piézo-électrique et les couches (5, 7) formant électrode sont disposées sur une couche de support en polysilicium et, dans lequel il est prévu une cavité (4) sur la face de cette couche support, qui est éloignée de la couche (5) inférieure formant électrode.

6. Agencement constitué de plusieurs résonateurs piézo-électriques à couches minces suivant l'une des revendications 1 à 5, dans lequel les résonateurs sont disposés sur la même puce, et dans lequel les résonateurs sont réglés sur au moins trois fréquences différentes de résonance.
